# EUROPÄISCHE PATENTSCHRIFT

(11) **EP 2 718 094 B1**
(45) Veröffentlichungstag und Bekanntmachung des Hinweises auf die Patenterteilung: **10.01.2018**
(21) Anmeldenummer: 11727413.4
(22) Anmeldetag: 06.06.2011
(51) Int. Cl.: H01L 21/66, B30B 15/06, G01L 5/00

(54) **VERFAHREN UND VORRICHTUNG ZUR ERMITTLUNG DER DRUCKVERTEILUNG ZUM BONDEN**
METHOD AND DEVICE FOR DETERMINING THE PRESSURE DISTRIBUTION FOR BONDING
PROCÉDÉ ET DISPOSITIF POUR LA DÉTERMINATION DE LA RÉPARTITION DE LA PRESSION POUR LE COLLAGE

(43) Veröffentlichungstag der Anmeldung: 16.04.2014
(73) Patentinhaber: Ev Group E. Thallner GmbH, 4782 St. Florian am Inn (AT)
(72) Erfinder: REBHAN, Bernhard, A-4680 Haag A. H. (AT); WIMPLINGER, Markus, A-4910 Ried im Innkreis (AT); BURGGRAF, Jürgen, A-4780 Schärding (AT)
(74) Vertreter: Schweiger, Johannes
(86) Internationale Anmeldenummer: PCT/EP2011/059308
(87) Internationale Veröffentlichungsnummer: WO 2012/167814

(56) Entgegenhaltungen:
- EP-A2- 1 182 028
- WO-A2-2011/013111
- DE-A1- 4 104 975
- DE-A1-102008 025 287
- JP-A- 10 311 764
- JP-A- 2007 114 107
- US-A- 6 033 987
- US-A1- 2008 087 069

## Beschreibung

Die Erfindung betrifft ein Verfahren und eine Vorrichtung zur Ermittlung der Druckverteilung in einer Grenzschicht zweier Werkzeuge über die Verformung viskoser oder plastisch verformbarer Medien gemäß Patentanspruch 1, 9 und 10.

Während eines Bondvorganges ist die Druckverteilung auf die zu verschweißenden Wafer von immenser Bedeutung. Die Druckverteilung ist eine direkte Eigenschaft der Oberflächenwelligkeit und Oberflächenrauheit der in Kontakt stehenden Oberflächen aller Werkzeuge, die über bzw. unter dem Wafer liegen. Zu den Werkzeugen zählen vor allem Heizer, Druckplatten, Kompensationsplatten, Aufnahmen (Bondchucks) etc. Die Kenntnis der Oberflächenwelligkeit und Oberflächenrauheit des Werkzeuges, dessen Oberfläche direkt mit einem der Wafer in Kontakt ist, reicht zur Berechnung der Druckverteilung nicht aus. Es ist daher mit gewöhnlichen Messmethoden wie AFM, Laserinterferometrie, Weißlichtinterferometrie nicht möglich, eine direkte und verlässliche Aussage über die Druckverteilung des Bondprozesses zu erhalten. Diese Messmethoden dienen einzig und allein der Bestimmung der Topographie der Oberfläche des Werkzeuges, welches direkt mit einem der zu verschweißenden Wafer in Kontakt ist. Die Homogenität der Druckverteilung hat einen sehr großen Einfluss auf die Bondqualität, woraus unmittelbar die Ausschussrate von kompletten gebondeten Wafern bzw. die Ausschussrate der funktionellen Komponenten, welche sich auf dem Wafer befinden, folgt. Verschiedene negative Konsequenzen im Falle einer unzureichenden Druckgleichmäßigkeit und/oder unebener Werkzeuge sollen hier kurz erwähnt werden. Im Falle nicht bzw. kaum verformbarer Bondinginterfaces, beispielsweise bei Metall-Metall Bonds, führt eine unzureichende Druckgleichmäßigkeit zu einem mangelhaften oder gar keinem Verbonden an jenen Stellen, an denen der Druck zu gering war. Beispielhaft seien hier Cu-Cu, Au-Au, Al-Al, W-W, Ni-Ni oder Ti-Ti Bonds erwähnt.

Für moderat verformbare Bondinginterfaces, beispielsweise Eutektika, welche während des Bondvorgangs durch eine flüssige Phase gehen, kann eine ungleichmäßige Druckverteilung zu einem inhomogenen Gefüge führen. Für sehr gut verformbare Bondinginterfaces, beispielsweise temporäre Bondingadhäsivs, führt die ungleichmäßige Druckverteilung am Beginn des Bondingprozesses ausschließlich zu einer inhomogenen Schichtdickenverteilung des Bondingadhäsivs.

Zur Bestimmung der Druckverteilung werden in der Industrie momentan vor allem Druckfolien verwendet, deren Material sensitiv auf Druckbelastung reagiert. Das Material verfärbt sich abhängig vom entsprechenden Druck unterschiedlich stark oder ändert die Intensität seiner Farbe. Eine optische Auswertung der Verfärbung oder Intensitätsänderung erlaubt Rückschlüsse auf die Druckverteilung, welche auf einen perfekten Wafer, der sich zwischen den Werkzeugen befindet, wirken würde. Die Druckfolien sind nur bei Raumtemperatur einsetzbar.

Die Oberflächenqualität aller übereinander fixierten Werkzeuge nimmt bei einer Vielzahl von Bondschritten ab, so dass von Zeit zu Zeit eine erneute Messung der Druckverteilung erforderlich ist, um den Ausschuss, insbesondere beim Waferbonden, zu minimieren. Der Verschleiß ist vor allem bei plastisch verformbaren Werkstoffen wie Metall nachweisbar. Bei einer nicht mehr tolerierbaren, ungünstigen Druckverteilung müssen im schlimmsten Fall alle übereinander fixierten Werkzeuge nachbearbeitet werden.

Alternative Messverfahren zur Ermittlung der Druckverteilung arbeiten mit Kraftmessdosen, mit welchen aber auf Grund der Größe der Kraftmessdosen nur eine sehr grobe Auflösung entlang der Aufnahme oder der Druckplatte möglich ist.
Die JP-A-2007114107 betrifft einen Halbleitersensor mit Piezoelementen zur Erfassung der Druckverteilung. Die JP-A-10311764 betrifft einen Wafer zur Messung einer Druckverteilung mittels einer druckleitfähigen Tinte. Aufgabe der vorliegenden Erfindungen ist es daher, ein, insbesondere automatisierbares, in Verfahrensabläufe integrierbares Verfahren sowie eine korrespondierende Vorrichtung vorzusehen, mit der die Druckverteilung zwischen den Werkzeugen in regelmäßigen Abständen möglichst einfach und genau gemessen werden kann. Dabei sollen die Mittel zur Messung möglichst wieder verwendbar sein. Das erfindungsgemäße Verfahren soll möglichst unter realen Prozessbedingungen anwendbar sein.

Diese Aufgabe wird mit den Merkmalen der Patentansprüche 1 und 9 gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, den Ansprüchen und/oder den Zeichnungen angegebenen Merkmalen. Bei Wertebereichen sollen auch innerhalb der genannten Grenzen liegende Werte als Grenzwerte offenbart und in beliebiger Kombination beanspruchbar sein. Vorrichtungsgemäße Merkmale sollen auch als verfahrensgemäße Merkmale offenbart gelten und umgekehrt.
Die vorliegende Erfindung beruht auf der Grundidee, durch Messung der, insbesondere lokalen, Verformung bzw. Größenordnung einer Messschicht, die zwischen die Aufnahme (Werkzeug) und die Druckplatte (Werkzeug) eingebracht wird, möglichst exakt auf die Druckverteilung rückschließen zu können. Die Dicke der Messschicht beim Messen ist kleiner als 200 µm, mit Vorzug kleiner als 100 µm mit größerem Vorzug kleiner als 50 µm, mit noch größerem Vorzug kleiner als 10 µm, mit größtem Vorzug kleiner als 5 µm mit allergrößtem Vorzug kleiner als 1 µm. Die bevorzugte Dicke der Messschicht hängt vor allem von dem zu verwendeten Bondprozess ab. Möchte man das erfindungsgemäße Verfahren verwenden, um die Druckverteilung für einen späteren Metall-Metallbond zu eruieren, wählt man erfindungsgemäß sehr dünne Schichten, mit Vorzug kleiner als 10 µm, mit größerem Vorzug kleiner als 5 µm, mit größtem Vorzug kleiner als 1 µm.

Für Bondprozesse mit moderat verformbaren Bondinterfaces, beispielsweise eutektischen Bonds, die durch eine flüssige Phase laufen, verwendet man erfindungsgemäß Schichtdicken kleiner als 50 µm, mit Vorzug kleiner als 10 µm, mit größtem Vorzug kleiner als 5 µm.

Für Bondprozesse mit sehr leicht verformbaren Bondinterfaces, beispielsweise temporären Bondingadhesiven, verwendet man erfindungsgemäß sehr dicke Schichten. Die Schichtdicken sind mit Vorzug kleiner als 200 µm, mit größerem Vorzug kleiner als 100 µm, mit größtem Vorzug kleiner 50 µm.

Überschneidungen der genannten Schichtdickenbereiche sind erlaubt und möglich, abhängig vom exakten Bondprozess und Material.

Damit ist das einzige Verbrauchsmaterial für das erfindungsgemäße Messverfahren beziehungsweise die erfindungsgemäße Messvorrichtung die Messschicht, die durch Druckbeaufschlagung beziehungsweise Aufeinander zu bewegen der Druckplatte und der Aufnahme verformt wird. Die relative, insbesondere parallel zur Oberfläche des Wafers bewirkte, Verformung der Messschicht wird anschließend gemessen und ausgewertet und auf Grund der, insbesondere lokalen, Verformung der Messschicht kann auf die Druckverteilung in der Grenzschicht zwischen den Werkzeugen rückgeschlossen werden. Die erfindungsgemäße Methode kann auch bei höheren Temperaturen eingesetzt werden, mit Vorzug über Raumtemperatur, mit größerem Vorzug über 200 °C, mit noch größerem Vorzug über 400 °C mit größtem Vorzug über 600 °C. Die Messung kann vorzugsweise durch Kameras erfolgen. Optiken dienen der Vergrößerung der zu messenden Schichten. Eine zweidimensionale Messung der Verformung in Aufsicht auf die Oberfläche der Messschicht, insbesondere orthogonal zur Oberfläche des Wafers, ist vorteilhaft. Es kann insbesondere die Änderung des Durchmessers bzw. die Ausbreitung der Messschicht erfasst werden. Gemäß einer vorteilhaften Ausführungsform der Erfindung ist vorgesehen, dass zwischen der Messschicht und den über bzw. unter ihr liegenden Werkzeugen zueinander ausgerichtete Wafer eingebracht werden. Auf diese Weise erfolgt die Verformung der Messschicht unter realistischen Bedingungen und die Entfernung der Messschicht kann, insbesondere rückstandsfrei nach Durchführung der Messung erfolgen. Mit realistischen Bedingungen sind Zustände gemeint, unter denen der eigentliche Bondvorgang erfolgt. Diese Zustände zeichnen sich durch erhöhte Temperatur, Vakuum, erhöhten Druck und ähnliche Parameter aus. Darüber hinaus sind die Leerlaufzeiten der Vorrichtung, soweit die Messung in-line erfolgt, dadurch minimiert, dass die Vorbereitung und auch die Messung unabhängig von den Werkzeugen bzw. der Bondinganlage erfolgen kann. Soweit die Form der Messschicht vor der Verformung gemessen wird, wird die Genauigkeit der Messung der Verformung deutlich erhöht. Eine Messung der Form der Messschicht nach der Verformung ist absolut notwendig um die entsprechende Kraft und damit den Druck im entsprechenden Punkt berechnen zu können.

Gemäß einer weiteren, vorteilhaften Ausführungsform der Erfindung ist vorgesehen, dass die Messschicht aus fluidem, insbesondere aushärtbaren, Material besteht. Entsprechend kann die Aufbringung oder Einbringung der Messschicht durch einen Droplet-Dispenser erfolgen, der eine gezielte und reproduzierbare Aufbringung, insbesondere in Form von Tropfen oder Bahnen, ermöglicht. Bei Aufbringung in definierter Größe oder eines definierten Volumens kann sogar auf die vorherige Vermessung der Messschicht vor Verformung der Messschicht verzichtet werden, wodurch eine weitere Beschleunigung des erfindungsgemäßen Verfahrens möglich wird.

Dies wird weiter optimiert, indem Verteilmittel, insbesondere in Form eines Droplet-Dispensers, zum definierten Verteilen der Messschicht zwischen der Aufnahme und der Druckplatte vorgesehen sind.

Mit Vorteil ist weiterhin vorgesehen, dass die Messung der Verformung, insbesondere der Ausbreitung, an einer Vielzahl von Positionen entlang der Messschicht, insbesondere optisch, erfolgt. Die Verformung der Messschicht erlaubt die Berechnung der Druckverteilung, welche von den Werkzeugen auf die Zwischenschicht ausgeübt wurde.

Indem zwischen der Messschicht und mindestens einem der Wafer eine haftreduzierende Schicht eingebracht wird, wird das Ablösen der Messschicht nach Durchführung der Messung der Verformung der Messschicht beschleunigt und vereinfacht.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Fig. 1a bis 1g: einen erfindungsgemäßen Verfahrensablauf gemäß einer Ausführungsform der Erfindung,
- Fig. 2: eine alternative Ausführungsform des erfindungsgemäßen Verfahrens,
- Fig. 3: eine weitere alternative Ausführungsform des erfindungsgemäßen Verfahrens,
- Fig. 4: eine erfindungsgemäße Messschicht in einer Aufsicht,
- Fig. 5: eine Seitenansicht einer erfindungsgemäßen Vorrichtung zur Ausführung des Verfahrens,
- Fig. 6: ein beispielhaftes Viskositätsdiagramm für ein Material und
- Fig. 7: Die Formel zur Berechnung der Kraft aus den Parametern der verformten und nichtverformten Schicht 7.

In den Figuren sind gleiche oder gleichwirkende Bauteile mit den gleichen Bezugszeichen gekennzeichnet.

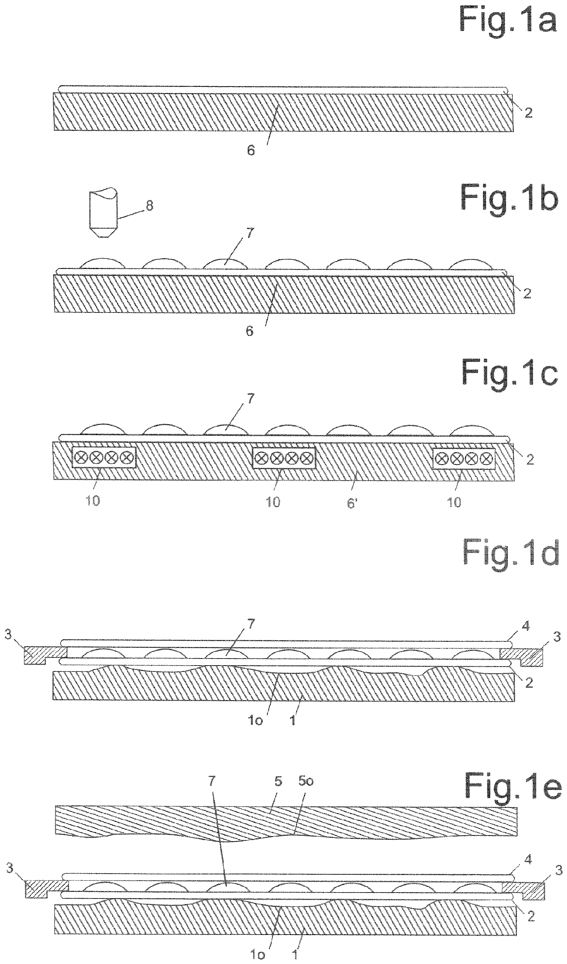

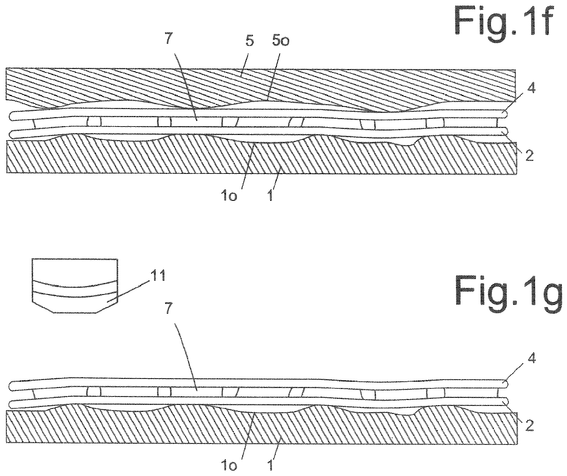

Gemäß Figur la wird ein zur Ermittlung der Druckverteilung vorgesehener Wafer 2 auf einer Platte 6 abgelegt. Bei der Platte 6 handelt es sich beispielsweise um einen Probenhalter innerhalb eines sogenannten Droplet-Dispensers, mit dem eine, insbesondere volumenmäßig, gezielte und reproduzierbare Aufbringung von Tropfen oder Bahnen möglich ist. Auf den Wafer 2 wird gemäß Figur 1b durch einen Dispenser 8, insbesondere in einem, vorzugsweise gitterförmigen, Raster oder in jeder beliebigen anderen Verteilung bzw. Matrix, eine Messschicht 7, insbesondere in Form einer Vielzahl von entlang des Rasters angeordneter Tropfen definierter Größe, aufgebracht. Der Wafer 2 wird anschließend, insbesondere mittels eines Roboterarms, auf eine Heizplatte 6' mit integrierten Heizungen 8 gelegt, um die in fluider Form vorliegende Messschicht 7 durch Verdampfung des in der Messschicht enthaltenden Lösungsmittels auszuhärten. Die Messschicht 7 kann insbesondere aus einem Polymer, mit Vorzug einem Thermoplast, bestehen. Die Heizplatte 6' ist vorzugsweise identisch mit der Platte 6 des Droplet-Dispensers.

Nach dem Aushärten der Messschicht 7 gemäß Figur 1c wird der Wafer 2 auf ein als Aufnahme ausgebildetes Werkzeug 1 der erfindungsgemäßen Vorrichtung, insbesondere mittels des Roboterarms, abgelegt und dort gegebenenfalls fixiert. Dadurch liegt der Wafer 2 auf einer Werkzeugoberfläche 10 de Werkzeugs 1, dessen Oberflächenebenheit beziehungsweise Rauhigkeit oder Welligkeit bzw. die sich daraus ergebende Druckverteilung entlang der Kontaktflächen durch das erfindungsgemäße Messverfahren beziehungsweise die erfindungsgemäße Messvorrichtung gemessen werden soll.

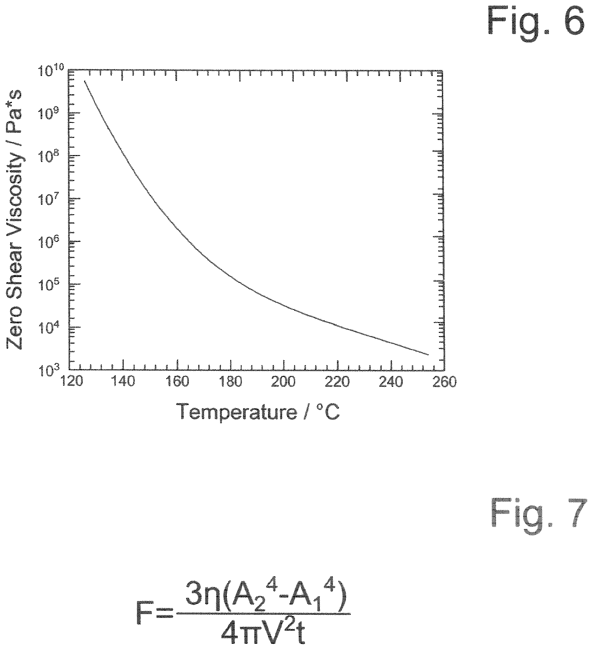

Auf Abstandshaltern 3, die auch als Klemmen zur Fixierung des Wafers 2 auf dem Werkzeug 1 dienen können, wird ein weiterer Wafer 4 abgelegt. Soweit die Messschicht 7 hochviskos genug ist, um unter der Last des weiteren Wafers 4 nicht verformt zu werden, ist auch eine Ausführung ohne Abstandshalter 3 denkbar. Die Viskosität der Messschicht 7 beim Verformen liegt insbesondere zwischen 10³ und 10¹⁰ Pa*s. Fig. 6 zeigt beispielhaft eine Viskositätskurve für ein Material im Temperaturbereich von 120 °C - 260 °C. Für die erfindungsgemäße Ausführungsform wird jenes Material verwendet, dessen geeigneter Viskositätsverlauf im gewünschten Temperaturbereich der Prozessbedingungen liegt.

Die Wafer 2 und 4 sollten mit Vorzug perfekt eben sein, keine Oberflächenrauhigkeit und keine Welligkeit besitzen. Da diese Bedingungen unrealistisch sind, sollten die zur Ermittlung der Druckverteilung vorgesehenen Wafer 2, 4 die gleichen Oberflächenrauhigkeitswerte und Welligkeitswerte besitzen wie jene Produktwafer, die im späteren Prozess gebonded werden sollen. Die Wafer 2, 4 sollen denselben Durchmesser besitzen wie die später zu bondenden Substratwafer. Des Weiteren sind sie mit Vorteil aus dem gleichen Material gefertigt. Sind die Wafer 2, 4 und die Substratwafer einkristallin, besitzen die Wafer 2, 4 mit Vorzug die gleiche kristallographische Orientierung wie die später zu bondenden Substratwafer. Damit kann gewährleistet werden, dass die Messergebnisse exakt die tatsächlich im Bondinterface des Produktwafers zu erwartende Druckverteilung repräsentiert.

Als Wafer 4 ist insbesondere ein Glaswafer erfindungsgemäß denkbar, um eine schnelle Auswertung mittels einer Auswerteoptik als Messmittel zur Messung der Verformung zu ermöglichen. Die Auswertung kann also nach Verformung der Messschicht 7 bei noch nicht abgelösten Wafern 2, 4 erfolgen.

Die Verformung der Messschicht 7 beziehungsweise der einzelnen Tropfen erfolgt durch ein als Druckplatte ausgebildetes Werkzeug 5, indem das Werkzeug 5 an das Werkzeug 1 angenähert wird. Eine Werkzeugoberfläche 5o des Werkzeuges 5 weist ebenfalls Oberflächenunebenheiten auf. Des Weiteren besitzen alle Werkzeuge 1', 1", 5', 5" über bzw. unter den Werkzeugen 5 bzw. 1 im Allgemeinen ebenfalls unebene Oberflächen. Durch das erfindungsgemäße Verfahren wird demnach die Druckverteilung der Kombination aller Werkzeuge 5, 5',... bzw. 1, 1',... ermittelt, indem die Verformung der Messschicht 7 ausgewertet wird. In der erfindungsgemäßen Methode werden mit Vorzug Wafer 2,4 verwendet, die in Material, Dicke, Oberflächenrauhigkeit, Welligkeit und anderen Parametern den später im eigentlichen Bondprozess verwendeten Wafern entsprechen.

Die Verformung der Messschicht 7 ist in der Figur lf dargestellt. Bei der Druckbeaufschlagung der Messschicht 7 durch die Bewegung des Werkzeuges 5 auf das Werkzeug 1 zu wird die Messschicht 7 plastisch verformt. Wegen der Unebenheit ergibt sich eine unterschiedliche Verformung an unterschiedlichen Orten, so dass auf Grund der unterschiedlichen Verformung der Tropfen eine Auswertung des Messergebnisses durch eine Auswerteeinrichtung ermöglicht wird. An Stellen, wo der Durchmesser der Tropfen stärker erhöht wird, ist das Werkzeug 5 an seiner Druckfläche 5o entsprechend näher an der Werkzeugoberfläche 1o des Werkzeuges 1, während bei entgegengesetztem Effekt die Entfernung höher ist.

Anschließend erfolgt nach Auseinanderbewegen des Werkzeuges 5 und des Werkzeuges 1 die Messung der Verformung der Messschicht 7 an einer Vielzahl von an der Messschicht 7 verteilten Messpunkten durch optische Messmittel 11, vorzugsweise optischen Mikroskopen und/oder CCD-Kameras, die eine entsprechende Auflösung aufweisen. Mit Vorteil ist es dabei vorgesehen, dass die Messung durch den Wafer 4 hindurch erfolgt, beispielsweise indem der Wafer für optisches Licht durchlässig ist, insbesondere als Glaswafer. Alternativ kann bei für optisches Licht opakem Wafer 4 mittels Infrarotstrahlung gemessen werden.

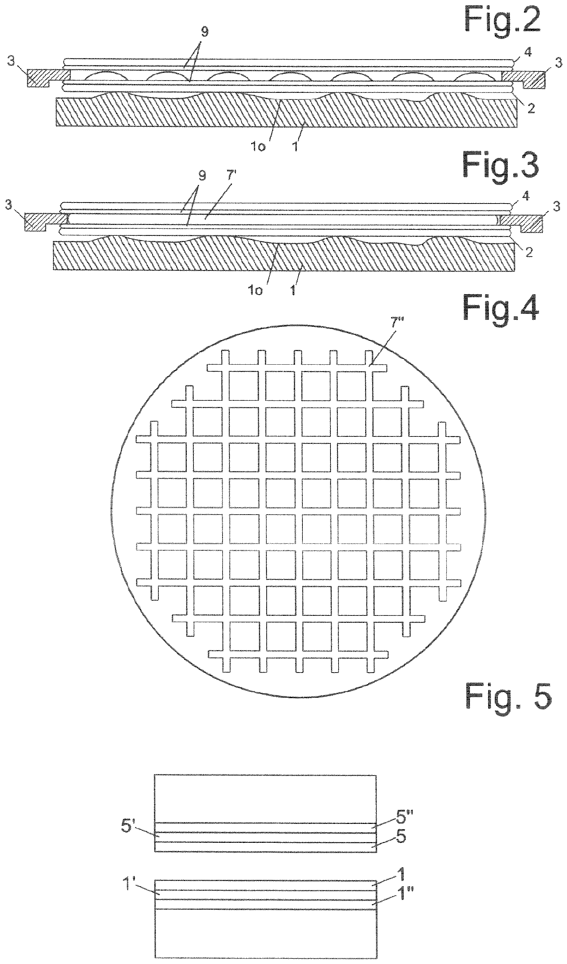

Die in der Figur 2 gezeigte alternative Ausführungsform ist dadurch gekennzeichnet, dass jeweils zwischen der Messschicht 7 und, insbesondere jedem, der Wafer 2, 4 eine haftreduzierende Schicht 9 auf dem Wafer vorgesehen ist, die vor Aufbringung der Messschicht 7 auf die Wafer 2, 4 jeweils aufgebracht wird.

In der Ausführungsform gemäß Figur 3 ist eine Messschicht 7' vorgesehen, die vollflächig, insbesondere über den gesamten Wafer 2 mit einer möglichst konstanten Dicke aufgebracht wird. Bei dieser Ausführungsform wird die Verformung der Messschicht 7' auf Grund der Dickenänderung entlang der Messschicht an einer Vielzahl von Positionen gemessen, so dass eine Dickenkarte der Messschicht 7' ermittelbar ist, insbesondere durch Messung vor und nach der Verformung. Als Messmittel können Interferometer, vorzugsweise Laserinterferometer vorgesehen sein. Durch die Druckbeaufschlagung/Verformung der Messschicht 7' und die Oberflächenunebenheiten der Druckplatte 5 und/oder Aufnahme 1 wird die Messschicht 7' an unterschiedlichen Positionen verdichtet, verdrängt, verdünnt, also entsprechend verformt, was in diesem Fall eine Dickenänderung zur Folge hat, da die Messschicht 7' plastisch verformbar ist.

In der in Figur 4 dargestellten Ausführung ist die Messschicht 7" als Gitter mit Bahnen vorgesehen, wobei die Bahnen im vorliegenden Fall orthogonal zueinander verlaufen. Eine winklige Anordnung der Bahnen zueinander wäre ebenfalls denkbar. Wesentlich ist dabei, dass die Bahnendicke möglichst einheitlich ist, damit eine reproduzierbare Messung der Verformung ermöglicht wird.

Die Berechnung der Druckverteilung erfolgt durch die Formal in Fig. 7. Die Viskosität η, der Querschnittsfläche A₁ des Tropfens vor der Verformung, der Querschnittsfläche A₂ des Tropfens nach der Verformung, das Tropfenvolumen V und die Zeit der Komprimierung t werden verwendet, um die Kraft F, die auf den Tropfen wirkt, zu berechnen. Der Druck berechnet sich durch die entsprechende Normierung auf den Tropfenquerschnitt. Durch die Berechnung der Kräfte bzw. Drücke an unterschiedlichen Positionen des Wafers kann eine Kraft- bzw. Druckkarte erstellt werden. Die Querschnittsflächen A₁ und A₂ sind die mittleren Querschnittsflächen der sich aus den Tropfen der Schicht 7 bildenden Zylinder, welche entstehen, wenn die Platte 4 auf der Schicht 7 abgelegt wird (Fig. 1f).

Bei den erfindungsgemäßen Ausführungsformen 7' und 7" erfolgt keine Absolutberechnung der Druckverteilung. Bei diesen beiden erfindungsgemäßen Ausführungsformen wird die Dickenverteilung der Schicht 7' bzw. des Gitters 7" nach einer angemessen langen Zeit, mit Vorzug einige Minuten, ausgewertet. Die Dickenverteilung als Funktion des Ortes stellt ein direktes Abbild der Druckverteilung zum Kontaktzeitpunkt dar. Diese relative Dickenverteilung reicht aus, um eine zumindest näherungsweise Aussage über die Schwachstellen der Werkzeuge zu erhalten. Die erfindungsgemäßen Ausführungsformen 7' und 7" werden nur angewandt, wenn man das Werkzeug für das Bondverhalten von sehr weichen Bondinterfaces, beispielsweise Bondingadhesiven, testen möchte. In der erfindungsgemäßen Ausführungsform 7" kann auch versucht werden, aus der sich ergebenden Linienverbreiterung des Gitters Rückschlüsse auf die (relative) Druckverteilung zu erlangen. Für die erfindungsgemäßen Ausführungsformen 7' und 7" werden üblicherweise niedrige Bondkräfte kleiner 15 kN, mit Vorzug kleiner 10 kN mit noch größerem Vorzug kleiner 5 kN verwendet.

### Bezugszeichenliste

- 1: Werkzeug
- 1o: Werkzeugoberfläche
- 2: Wafer
- 3: Abstandshalter
- 4: Wafer
- 5: Werkzeug
- 5o: Werkzeugoberfläche
- 6, 6': Platte
- 7, 7', 7": Messschicht
- 8: Dispenser
- 9: haftreduzierende Schichten
- 10: Heizung
- 11: Messmittel

## Patentansprüche

1. Verfahren zur Ermittlung der Druckverteilung zum Bonden eines ersten Substrats mit einem zweiten Substrat mit folgenden Schritten,
- Einbringen einer Messschicht (7, 7', 7") zwischen ein erstes Werkzeug (1) zur Aufnahme des ersten Substrats und ein zu dem ersten Werkzeug (1) ausgerichtetes und gegenüberliegendes zweites Werkzeug (5) zum Bonden der Substrate,
- Verformung der Messschicht (7, 7', 7") durch Annäherung der Werkzeuge (1, 5),
- optische Messung der Verformung der Messschicht (7, 7', 7") und
- Berechnung der Druckverteilung auf Grund der Messung der Verformung.

2. Verfahren nach Anspruch 1, bei dem zwischen der Messschicht (7, 7', 7") und dem ersten Werkzeug (1) und/oder zwischen der Messschicht (7, 7', 7") und dem zweiten Werkzeug (5), insbesondere zueinander ausgerichtete, Wafer (2, 4) eingebracht werden.

3. Verfahren nach einem der vorhergehenden Ansprüche, bei der die Form der Messschicht (7, 7', 7") vor der Verformung, insbesondere nach Einbringung der Messschicht (7, 7', 7") gemessen wird.

4. Verfahren nach einem der vorhergehenden Ansprüche, **dadurch gekennzeichnet, dass** die Messschicht (7, 7', 7") aus fluidem, insbesondere aushärtbarem, vorzugsweise nach Aushärtung plastisch verformbaren, Material besteht.

5. Verfahren nach einem der vorhergehenden Ansprüche, **dadurch gekennzeichnet, dass** Dispenser (8) zum definierten Verteilen der Messschicht (7, 7', 7") zwischen dem ersten Werkzeug (1) und dem zweiten Werkzeug (5) vorgesehen sind.

6. Verfahren nach einem der vorhergehenden Ansprüche, **dadurch gekennzeichnet, dass** die Messung der Verformung an einer Vielzahl von Positionen entlang der Messschicht (7, 7', 7") erfolgt.

7. Verfahren nach einem der vorhergehenden Ansprüche, **dadurch gekennzeichnet, dass** die Messschicht (7, 7', 7") durch Tropfenaufbringung, insbesondere auf dem Wafer (2), hergestellt wird.

8. Verfahren nach Anspruch 2, bei dem zwischen der Messschicht (7, 7', 7") und mindestens einem der Wafer (2, 4) eine haftreduzierende Schicht (9) eingebracht wird.

9. Vorrichtung zur Ermittlung der Druckverteilung zum Bonden eines ersten Substrats mit einem zweiten Substrat mit:
- Einbringmitteln (8) zum Einbringen oder Aufbringen einer Messschicht (7, 7', 7") zwischen ein erstes Werkzeug (1) und ein zum ersten Werkzeug (1) ausgerichtetes und gegenüberliegendes zweites Werkzeug (5),
- Verformungsmitteln (1, 5) zur Verformung der Messschicht (7, 7', 7") durch Aufeinander zu bewegen der Werkzeuge (1, 5),
- optischen Messmitteln zur Messung der Verformung der Messschicht (7, 7', 7") und
- Berechnungsmitteln zur Berechnung der Druckverteilung.

## Claims

1. A method for determining the pressure distribution for wafer bonding of a first substrate to a second substrate, with the following steps,
- placing a measurement layer (7, 7', 7") between a first tool (1) for holding the first substrate and an opposite second tool (5) which is aligned to the first tool (1) for bonding of the substrates,
- deformation of the measurement layer (7, 7', 7") by bringing the tools (1, 5) closer to one another,
- optical measurement of the deformation of the measurement layer (7, 7', 7") and
- computation of the pressure distribution based on the measurement of the deformation.

2. The method as claimed in Claim 1, wherein between the measurement layer (7, 7', 7") and the first tool (1) and/or between the measurement layer (7, 7', 7") and the second tool (5) wafers (2, 4) are introduced which are especially aligned to one another,

3. The method as claimed in one of the preceding claims, wherein the shape of the measurement layer (7, 7', 7") is measured before deformation, especially after the measurement layer (7, 7', 7") is introduced.

4. The method as claimed in one of the preceding claims, wherein the measurement layer (7, 7', 7") consists of a fluid, especially curable material which can preferably by plastically deformed after curing.

5. The method as claimed in one of the preceding claims, wherein there are dispensers (8) for defined distribution of the measurement layer (7, 7', 7") between the first tool (1) and the second tool (5).

6. The method as claimed in one of the preceding claims, wherein the deformation is measured at a plurality of positions along the measurement layer (7, 7', 7").

7. The method as claimed in one of the preceding claims, wherein the measurement layer (7, 7', 7") is produced by application of droplets, especially on the wafer (2).

8. The method as claimed in Claim 2, wherein an adhesion-reducing layer (9) is introduced between the measurement layer (7, 7', 7") and at least one of the wafers (2, 4).

9. A device for determining the pressure distribution for wafer bonding of a first substrate to a second substrate, with:
- introducing means (8) for introducing or applying a measurement layer (7, 7', 7") between a first tool (1) and an opposite second tool (5) which is aligned to the first tool (1),
- deformation means (1, 5) for deformation of the measurement layer (7, 7', 7") by moving the tools (1, 5) toward one another,
- measurement means for optical measuring of the deformation of the measurement layer (7, 7', 7") and
- computation means for computing the pressure distribution.

## Revendications

1. Procédé de détermination de la répartition de la pression pour lier un premier substrat à un second substrat comprenant les étapes suivantes :
- introduction d'une couche de mesure (7, 7', 7") entre un premier outil (1) pour recevoir le premier substrat et un second outil (5) opposé et aligné vers le premier outil (1), pour lier les substrats,
- déformation de la couche de mesure (7, 7', 7") par rapprochement des outils (1, 5),
- mesure optique de la déformation de la couche de mesure (7, 7', 7") et
- calcul de la répartition de la pression du fait de la mesure de la déformation.

2. Procédé selon la revendication 1, dans lequel des tranches (2, 4), alignées en particulier l'une vers l'autre, sont introduites entre la couche de mesure (7, 7', 7") et le premier outil (1) et/ou entre la couche de mesure (7, 7', 7") et le second outil (5).

3. Procédé selon l'une des revendications précédentes, dans lequel la forme de la couche de mesure (7, 7', 7") avant la déformation, en particulier après introduction de la couche de mesure (7, 7', 7"), est mesurée.

4. Procédé selon l'une des revendications précédentes, **caractérisé en ce que** la couche de mesure (7, 7', 7") est constituée de matériau fluide, en particulier durcissable, de préférence déformable plastiquement après durcissement.

5. Procédé selon l'une des revendications précédentes, **caractérisé en ce que** des distributeurs (8) pour la répartition définie de la couche de mesure (7, 7', 7") entre le premier outil (1) et le second outil (5) sont prévus.

6. Procédé selon l'une des revendications précédentes, **caractérisé en ce que** la mesure de la déformation est effectuée à une pluralité de positions le long de la couche de mesure (7, 7', 7").

7. Procédé selon l'une des revendications précédentes, **caractérisé en ce que** la couche de mesure (7, 7', 7") est fabriquée par application de gouttes, en particulier sur la tranche (2).

8. Procédé selon la revendication 2, dans lequel une couche de réduction d'adhérence (9) est introduite entre la couche de mesure (7, 7', 7") et au moins une des tranches (2, 4).

9. Dispositif de détermination de la répartition de la pression pour lier un premier substrat à un second substrat comprenant :
- des moyens d'introduction (8) pour introduire ou appliquer une couche de mesure (7, 7', 7") entre un premier outil (1) et un second outil (5) opposé et aligné vers le premier outil (1),
- des moyens de déformation (1, 5) pour déformer la couche de mesure (7, 7', 7") par rapprochement des outils (1, 5),
- des moyens de mesure optiques pour mesurer la déformation de la couche de mesure (7, 7', 7") et
- des moyens de calcul pour calculer la répartition de la force.
